Europäisches Patentamt

European Patent Office

Office européen des brevets

(19)

(11) **EP 0 552 316 B1**

(12) **EUROPÄISCHE PATENTSCHRIFT**

(45) Veröffentlichungstag und Bekanntmachung des Hinweises auf die Patenterteilung:
**13.01.1999 Patentblatt 1999/02**

(21) Anmeldenummer: **92904753.8**

(22) Anmeldetag: **19.02.1992**

(51) Int Cl.⁶: **H04B 10/18**, H04B 1/62

(86) Internationale Anmeldenummer:
**PCT/EP92/00342**

(87) Internationale Veröffentlichungsnummer:
**WO 92/22964 (23.12.1992 Gazette 1992/32)**

(54) **SCHALTUNG ZUM VERRINGERN VON INTERMODULATION BEIM EINSATZ VON HALBLEITERLASERN FÜR DIE OPTISCHE NACHRICHTENÜBERTRAGUNG**

CIRCUIT FOR REDUCING INTERMODULATION ON THE USE OF SEMICONDUCTOR LASERS FOR OPTICAL INFORMATION TRANSMISSION

CIRCUIT REDUCTEUR DE L'INTERMODULATION LORS DE L'UTILISATION DE LASERS A SEMICONDUCTEUR POUR LA TRANSMISSION OPTIQUE D'INFORMATIONS

(84) Benannte Vertragsstaaten:
**CH DE DK ES FR GB LI NL**

(30) Priorität: **18.06.1991 DE 4120029**

(43) Veröffentlichungstag der Anmeldung:
**28.07.1993 Patentblatt 1993/30**

(73) Patentinhaber: **FUBA Communications Systems GmbH**
**31162 Bad Salzdetfurth (DE)**

(72) Erfinder: **Ciemniak, Hartmut**
**W-3201 Holle 1 (DE)**

(74) Vertreter: **Skora, Michael, Dipl.-Ing. et al**
**Patentanwälte**
**Kosel, Sobisch & Skora,**
**Odastrasse 4 a**
**37581 Bad Gandersheim (DE)**

(56) Entgegenhaltungen:
**EP-A- 0 423 666        DE-A- 2 656 436**
**DE-A- 3 307 309**

- **PATENT ABSTRACTS OF JAPAN vol. 14, no. 560 (E-1012) 13. Dezember 1990 & JP,A,2 241 215 ( HITACHI )**

**Beschreibung**

Die Erfindung betrifft eine Schaltungsanordnung, mit der bei optischer Nachrichtenübertragung mit großen Frequenzbereichen auf der Basis analoger Modulation - z.B. in Breitbandkabel-Systemen- Intermodulationserscheinungen verringert werden sollen, die auf die Nichtlinearität des optischen Ausgangssignals der Halbleiter-Laser zurückzuführen sind.

Derartige "... nichtlineare Verzerrungen lassen sich", so Meinke/Gundlach [1], "durch geeignete, aber sehr aufwendige elektronische Maßnahmen reduzieren, z.B. durch Vorverzerrungen oder Gegenkopplung. " Diese Aussage ist insofern zu ergänzen, als der Aufwand und damit auch die Kosten bei den bekannten Lösungsprinzipen in stärkerem Maß als die angestrebte - und bisher erzielte - Qualität steigen, und verschiedentlich Nebeneffekte auftreten, die ihrerseits zusätzliche Maßnahmen der Kompensation erfordern.

Ein charakteristisches Beispiel stellt die im allgemeinen verwendete Vorverzerrungsschaltung dar. In DE 33 07 309 A1, die eine über das Ausgangssignal geregelte Vorverzerrung betrifft, ist ohne detaillierte Beschreibung die Möglichkeit einer ungeregelten Vorverzerrung erwähnt.

Aus der Praxis ist jedoch bekannt:
Aus dem Signalstrom zur Treiberschaltung des Lasers wird ein Anteil Signalenergie ausgekoppelt, daraus werden in einem nichtlinearen Netzwerk Intermodulationsprodukte - Verzerrungen - erzeugt, wie sie auch im Laser entstehen, und diese Verzerrungen werden, mit einer Phasendrehung, über ein Amplituden-Anpaßglied geführt und wieder in den Signalstrom eingekoppelt. Das Netzwerk liefert symmetrische Mischprodukte mit Anteilen 2. Ordnung und bzw. oder 3. Ordnung und außerdem Anteile höherer Ordnung, die vernachlässigt werden können.

Die anteilige Zusammensetzung der Mischprodukte hängt von der Kennliniencharakterstik des Vorverzerrungs-Netzwerks ab. Die einzelnen Anteile stehen jeweils in festen, nicht veränderlichen Verhältnissen zueinander. Die in den Signalstrom eingekoppelten Intermodulationsprodukte befinden sich in Phasenopposition zu den im Laser - oder einem anderen Netzwerk, dessen Kennliniencharakteristik linearisiert werden soll - entstehenden Verzerrungen und führen zu einer Kompensation. Voraussetzung ist allerdings, daß die gegenphasigen Mischprodukte der Vorverzerrung und des Lasers in den Beträgen übereinstimmen.

Aus dieser Bedingung resultiert der wesentliche Nachteil des Prinzips: Die heute verfügbaren Laser weisen Qualitätsunterschiede auf, die sich vor allem in Unregelmäßigkeiten der Kennliniencharakteristika niederschlagen. So entstehen von Laser zu Laser andersartig zusammengesetzte Intermodulationen, vielfach mit Asymmetrien der in den Übertragungsbereich fallenden Summen- und Differenzprodukte nach Betrag und Phase. Dies gilt speziell für die pegelhöheren, die Übertragungsgüte entscheidend beeinflussenden Produkte 2. Ordnung.

Es ist verständlich, daß die von dem VorverzerrungsNetzwerk erzeugten Koeffizienten 2. und 3. Ordnung mit ihren festen - oft auch ihrerseits nicht definierten - Verhältnissen zueinander nur selten mit der Lasercharakteristik korrelieren, und daß sich auf diese Weise die im Laser erzeugten Verzerrungen weder mit ausreichend vorherbestimmbarem noch mit, insgesamt gesehen, befriedigendem Erfolg über die gesamte Nutzsignal-Bandbreite kompensieren lassen.

Die einzige bisher denkbare Lösung des Problems bestände darin, Laser mit über einen extrem großen Bereich linearer Charakteristik zu verwenden - die sind sehr teuer - oder, unter den preisgünstigeren Lasern nach solchen zu suchen, deren Kennliniencharakteristik der des Vorverzerrungs-Netzwerks weitgehend angepaßt ist. Diese Methode ist aufwendig und kann trotzdem keinen befriedigenden Erfolg garantieren.

Der Erfindung liegt die Aufgabe zugrunde, eine Schaltung nach dem Prinzip der Vorverzerrung zu schaffen, mit der für die breitbandige optische Signalübertragung mit analoger Modulation Störungen durch Intermodulation effektiv und weitgehend unabhängig von der Kennliniencharakteristik des verwendeten Lasers kompensiert werden, und die durch Einstellung bzw. Regelung an die Kennliniencharakteristik des Lasers angepaßt werden kann.

Diese Aufgabe wird erfindungsgemäß durch die im kennzeichnenden Teil des Hauptanspruchs angegebenen Merkmale gelöst. Im Unteranspruch ist eine vorteilhafte Ausführungsvariante der Erfindung dargestellt.

Mit der erfindungsgemäßen Schaltungsanordnung werden zum einen die Intermodulationsprodukte zur Korrektur der Lasercharakteristik separat, getrennt nach den Produkten der 2. und denen der 3. Ordnung, und darüber hinaus die Produkte der 2. Ordnung - mit dem höchsten Störpegel - getrennt nach Summen- und Differenzprodukten generiert. Das geschieht in den entsprechenden Zweigen des linearen Netzwerks der Schaltung. Zum anderen werden die Summen- und die Differenzprodukte der 2. Ordnung - die das nichtlineare Netzwerk noch symmetrisch verlassen - und die Mischprodukte der 3. Ordnung, jedes separat für sich, in den Zweigen des linearen Netzwerks nach Phase und Amplitude entsprechend der speziellen Kennliniencharakteristik des jeweiligen Lasers aufbereitet, bevor sie summmiert und in den Signalstrom zur Intensitätsmodulierung des Lasers eingekoppelt werden. Die Zweige des linearen Netzwerks für die einzelnen Intermodulationsanteile und die Allpässe vor dem nichtlinearen Netzwerk sind - zur Anpassung an die Lasercharakteristik - abgleichbar.

Der wesentliche Vorteil der Erfindung besteht darin, daß die Schaltung zur Kompensation der vom Laser erzeugten störenden Intermodulation breitbandig eine extrem feinfühlige, weil vektorweise Anpassung der gegenphasigen Vorverzerrungsprodukte gestattet, so daß die Störunterdrückung entscheidend verbessert und die Abhängigkeit von den Laser-Parametern verringert wird. Die Anpassung kann als einmalige Voreinstellung, als Korrektur-Einstellung in bestimmten Zeitabständen und, auf geeignete Weise, als Regelung realisiert werden.

Das erfindungsgemäße Prinzip ist, wie schon angedeutet, über den Einsatz in der optischen Nachrichtenübertragung hinaus auch bei beliebigen anderen Netzwerken anwendbar, bei denen auf Grund ungenügender Linearität der Kennliniencharakteristika unerwünschte Störeffekte entstehen. Es ist weiterhin denkbar, derartige Schaltungsanordnungen modular aufzubauen, entweder in Integration mit dem zu entstörenden Bauelement oder als separate, weitgehend universelle, konfektionierte Baugruppe.

Die Erfindung wird im folgenden an Hand von Beispielen näher erläutert. In der zugehörigen Zeichnung zeigen

Figur 1.      Schaltung zur Vorverzerrung nach dem bekannten Stand der Technik
Figur 2.      Prinzipschaltbild nach der Erfindung
Figur 3.      Zweig des nichtlinearen Netzwerks nach Figur 2
Figur 4.      Vereinfachte Ausführungsvariante der Erfindung

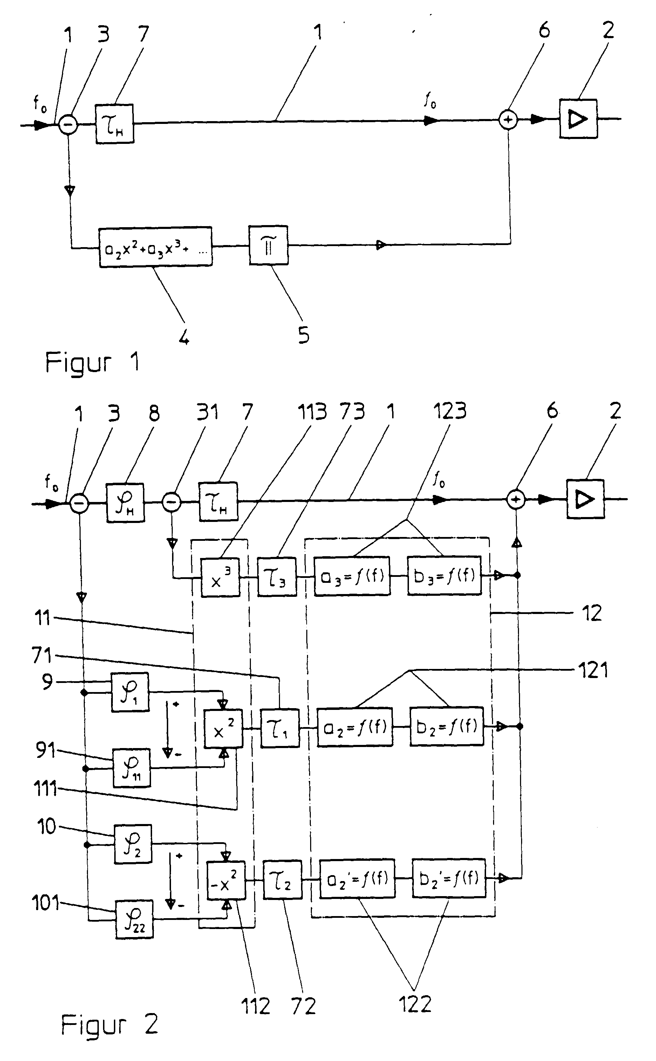

Figur 1 zeigt das Blockschaltbild einer herkömmlichen Vorverzerrung zur Korrektur der Kennliniencharakteristik eines nichtlinearen Netzwerks, z.B. einer nach dem Verfahren der analogen Modulation intensitätsgesteuerten Laserdiode.

Aus dem Leitungsweg 1 des elektrischen Breitbandsignals $f_0$ wird vor der Treiberschaltung 2 für die Laserdiode über den Koppler 3 ein Anteil Signalenergie entnommen und einem Netzwerk 4 mit nichtlinearer Kennliniencharakteristik zugeführt. Das Netzwerk 4 erzeugt mit dem Nutzsignalanteil - bei gleichzeitiger Unterdrückung dieses Anteils - symmetrische Intermodulationsprodukte, die über ein Amplituden-Anpaßglied 5 und den weiteren Koppler 6 mit einer Phasendrehung in den Leitungsweg 1 gegeben werden. Die dem Nutzsignal auf diese Weise zugesetzte Intermodulation, die "Vorverzerrung", besteht im wesentlichen aus Mischprodukten 2. Ordnung ($a_2x^2$) und bzw. oder 3. Ordnung ($a_3x^3$), die in einem ganz bestimmten festen Verhältnis zueinander stehen. Die Anordnung wird ergänzt durch das Laufzeitglied 7 in der Leitung 1.

Die Schaltung kann - wie schon angedeutet - nicht oder nur grob an unterschiedliche Kennliniencharakteristika der zu entstörenden Netzwerke angepaßt werden. Ein Ausweg bestände, wie angedeutet, in der Auswahl des am besten passenden Lasers - eine Methode, die heute jedoch weder prinzipiell noch vom Aufwand her überzeugen kann.

Bei der erfindungsgemäßen Schaltung nach Figur 2 bezeichnen 8, 9 und 91 sowie 10 und 101 einstellbare Allpässe (nämlich erster Allpass 8, zweiter Allpass 9, dritter Allpass 10, vierter Allpass 91, fünfter Allpass 101) und 11 das nichtlineare erste Netzwerk mit den Zweigen 111, 112 und 113 (erster Zweig 111, zweiter Zweig 112, dritter Zweig 113). Mit 71, 72 und 73 sind weitere Laufzeitglieder und mit 12 das lineare zweite Netzwerk mit den Zweigen 121, 122 und 123 benannt (erster Zweig 121, zweiter Zweig 122, dritter Zweig 123).

Gemäß der Erfindung sind im Leitungsweg des elektrischen Breitbandsignals $F_0$ zwei Koppler 3 und 31 (erster Koppler 3, zweiter Koppler 31) zur Energieentnahme angeordnet, und dazwischen der erste Allpass 8.

Für den Normalfall sind die Allpässe 8, 9, 10 so abgeglichen, daß sie phasengleich sind. Dazu gilt generell die Bedingung, daß Allpass 91 gegen Allpass 9 und Allpass 101 gegen Allpass 10 um 90° verschoben sind.

An den Zweigen 111 und 112 des nichtlinearen Netzwerks liegen also jeweils $f_0$ und $f_0$-90° an. Damit werden nach dem Prinzip der Einseitenband-Mischung mit unterdrücktem Träger (hier des $f_0$-Anteils) im Zweig 111 ausschließlich Summenprodukte 2. Ordnung (oberes Seitenband, OSB) und im Zweig 112 ausschließlich Differenzprodukte 2. Ordnung (unteres Seitenband, USB) erzeugt. Sie gelangen über die Laufzeitglieder 71 und 72 auf die Zweige 121 und 122 des linearen Netzwerks, in denen die amplitudenmäßige [$a=f_{(f)}$] und die phasenmäßige [$b=f_{(f)}$] Anpassung an die Lasercharakteristik erfolgt.

Im Zweig 113 des nichtlinearen Netzwerks werden aus dem über 31 ausgekoppelten $f_0$-Anteil ausschließlich Mischprodukte der 3. Ordnung erzeugt, ebenfalls mit Unterdrückung von $f_0$. Hier genügt ein vereinfachter Schaltungsaufbau, denn die Mischprodukte 3. Ordnung haben im Vergleich zu denen der 2. Ordnung einen vergleichsweise geringen Pegel und einen größeren Intermodulationsabstand. Die Mischprodukte 3. Ordnung können der Lasercharakteristik im Zweig 123 des linearen Netzwerks 12 in Phase und Amplitude angepaßt werden.

Die Vorverzerrungs-Produkte gelangen mit der im Netzwerk 12 differenziert eingestellten Phasenverschiebung gegen das Nutzsignal $f_0$ in den Leitungsweg 1. Sollte eine bestimmte Lasercharakteristik eine zusätzliche Phasenverschiebung des Nutzsignals erfordern, so läßt sich dies durch entsprechenden Vorabgleich des Allpasses 8 und dazu der Allpässe 8, 9 und 10 untereinander - mit der entsprechenden Anpassung der Allpässe 91 und 101 - realisieren.

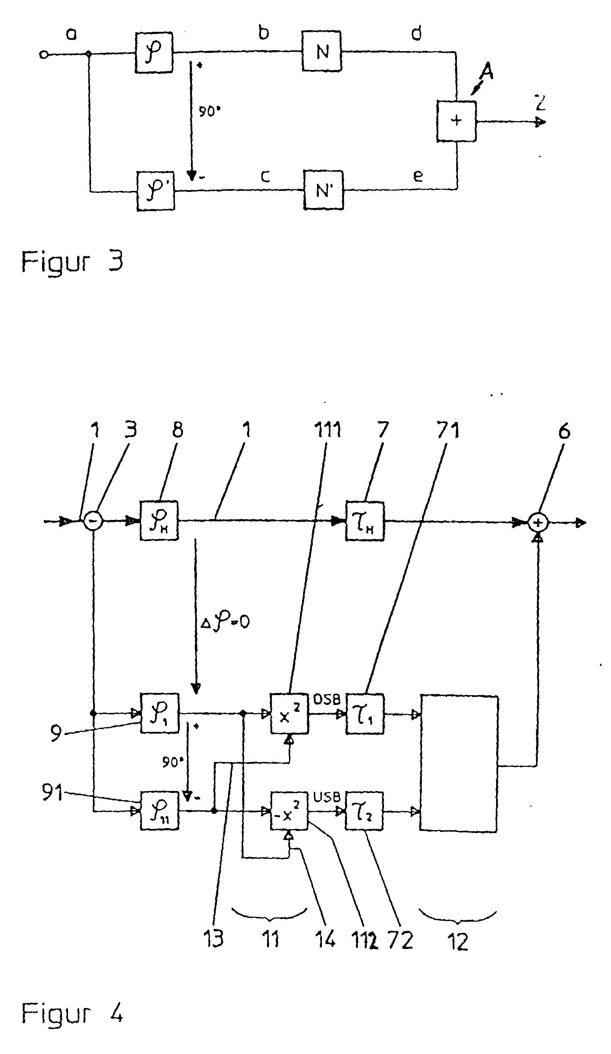

Das Prinzip der Aufbereitung der Mischprodukte 2. Ordnung im nichtlinearen Netzwerk der Schaltung nach Figur 2 wird an Hand von Figur 3 näher erläutert:
Mit N und N' sind nichtlineare Vierpole bezeichnet, deren Eingangsamplituden so eingestellt sind, daß jeweils nur der quadratische Kennlinienteil zur Wirkung kommt.

Der ausgekoppelte Signalanteil a passiert die Allpässe φ und φ' und gelangt als Signal b auf N und als Signal c, mit einer Phasenverschiebung um 90° gegen b, auf N'. Aus den Signalen b und c mit den Frequenzen $f_1$, $f_2$, $f_3$, ... entstehen in N und N' ausschließlich Produkte 2.Ordnung. hier als d und e bezeichnet:

$$2f_1, 2f_2, 2f_3, ... \qquad \text{(1. Harmonische)},$$

$$f_1+f_2, f_1+f_3, f_2+f_3, ... \qquad \text{(Summenprodukte)},$$

$$f_1-f_2, f_1-f_3, f_3-f_3, ... \qquad \text{(Differenzprodukte)}.$$

Im Addierer A werden d und e zusammengefaßt.

Liegen die quadratischen Kennlinien von N und N' nun beide im 1. und im 2. Quadranten, so ergibt sich am Ausgang z eine Addition der Summenprodukte und der Harmonischen, während die Differenzprodukte aus d und e sich gegenseitig aufheben. Am Ausgang z liegt somit das Signal OSB an.

Liegt dagegen die quadratische Kennlinie von N im 1. und im 2. Quadranten und die von N' im 3. und im 4. Quadranten, so ergibt sich am Ausgang z eine Addition der Differenzprodukte, während die Summenprodukte und die Harmonische aus d und e sich kompensieren. Am Ausgang z liegt dann das Signal USB an.

Die Signale b und c werden durch symmetrische Kompensation unterdrückt und erscheinen in den Ausgangssignalen nicht mehr.

Figur 4 zeigt eine vereinfachte Ausführungsvariante der erfindungsgemäßen Schaltung.
Hier sind die Allpässe 8 und 9 so abgeglichen, daß zwischen dem Nutzsignal in der Leitung 1 und dem VorverzerrungsZweig keine Phasendifferenz auftritt ($\varphi_H - \varphi_1 = 0$).

Die Bauelemente zum Generieren der Produkte 3. Ordnung sind hier nicht dargestellt, können aber, mit erfindungsgemäßer Wirkung, eingefügt werden.

Es hat sich gezeigt, daß diese Ausführungsform für das gros der Anwendungsfälle ausreicht, um die von einem Laser erzeugte Intermodulation zufriedenstellend und mit gegenüber den Lösungen des Stands der Technik ebenfalls wesentlich verbessertem Erfolg zu kompensieren.

Literatur

[1] Meinke/Gundlach: Taschenbuch der Hochfrequenztechnik. 4. Auflage. Springer-Verlag, Berlin, Heidelberg, New York, Tokio 1986, R 63.

**Patentansprüche**

1. Schaltung zur Verringerung von Intermodulation beim Einsatz von Halbleiterlasern für die optische Nachrichtenübertragung durch eine zusätzlich erzeugte, gegenphasige Intermodulation, die senderseitig vor einer Laser-Treiberschaltung (2) aus einem Nutzsignal auf einer Nutzsignalleitung (1) gewonnen und dem Nutzsignal aufaddiert wird, dadurch gekennzeichnet, daß

- die Schaltung ein erstes Netzwerk (11) mit nichtlinearer Charakteristik und ein nachgeordnetes zweites Netzwerk (12) mit linearer Charakteristik aufweist, die über erste und zweite Koppler (3;31) zum Abzweigen von Signalenergie und einen Ein-Koppler (6) zum Einkoppeln des behandelten Signalanteils mit der Nutzsignalleitung (1) vor der Treiberschaltung (2) verbunden sind,

- daß das erste Netzwerk (11) aus einem ersten Zweig (111) zur Summenbildung und einem zweiten Zweig (112) zur Differenzbildung von Mischprodukten der 2. Ordnung nach dem Prinzip der Einseitenbandmischung mit Trägerfrequenzunterdrückung und einem dritten Zweig (113) zur Aufbereitung von Mischprodukten der 3. Ordnung besteht,

- daß das zweite Netzwerk (12) derart ausgebildet ist, daß mit ihm eine separate Anpassung der in dem ersten, zweiten und dritten Zweig (111, 112 und 113) gewonnenen Intermodulationsprodukte nach Phase und Betrag - gegenphasig - an die jeweilige Charakteristik des Lasers durchführbar ist,

- daß Allpässe (8, 9, 10, 91, 101), vorzugsweise Allpässe 2. Grades vorgesehen sind, die abgleichbar sind, wobei ein zweiter und ein dritter Allpass (9;10) als erste Eingänge in die Eingangsleitungen des ersten und zweiten Zweiges (111,112) eingebaut sind vorzugsweise phasengleich mit einem ersten Allpass (8) in der Nutzsignalleitung (1) sind und ein vierter Allpass (91), der als zweiter Eingang für den ersten Zweig (111) vorgesehen ist, gegen den zweiten Allpass (9) um 90° phasenverschoben ist und ein fünfter Allpass (101), der als zweiter Eingang für den zweiten Zweig (112) vorgesehen ist, gegen den dritten Allpass (10) um 90° phasenverschoben ist, und

- daß in die Nutzsignalleitung (1) und hinter dem ersten und zweiten Zweig (111,112) des ersten Netzwerks (11) Laufzeitglieder (7,71,72) eingeschaltet sind.

2. Schaltung zur Verringerung von Intermodulation nach Anspruch 1, gekennzeichnet durch eine Parallelansteuerung des ersten und zweiten Zweigs (111,112) des nichtlinearen Netzwerks über eine erste bzw. zweite Leitung (13,14) hinter einem gemeinsamen Allpaß-Paar (9, 91) zur Aufteilung und Phasenverschiebung des Nutzsignal-Anteils.

**Claims**

1. Circuit reducing the intermodulation products on a transmission signal when using semiconductor lasers in optical telecommunications by means of an artificial counter-phased intermodulation signal generated on the transmitter side by using laser driver stage (2) from a useful signal on a useful signal line (1) which is then added on to the useful signal characterized by the fact that

 - the circuit provides a first network (11) with a non-linear characteristic and a subsequent second network (12) with a linear characteristic connected to the useful signal line (1) upstream of the driver stage (2) through first and second couplers (3;31) for tapping signal power and an injector (6) to inject the processed portion of the signal;

 - the first network (11) consists of a first branch (111) for summation and a second branch (112) for subtraction of second order beat products according to the principle of SSB mixing with carrier frequency cancelling and a third branch (113) for processing third order beat products;

 - the second network (112) is designed in such a way as to use it to separately match the intermodulation products generated in branches (111, 112 and 113) in terms of phase and amount, i. e. to counter-phase them, to each individual laser characteristic;

 - all pass filters (8, 9, 10, 91, 101), preferentially 2nd grade (adjustable) all pass filters are provided, a second and third all pass filter (9; 10) being inserted as first inputs into the input lines of the first and second branch (111, 112) preferentially in-phase with the third all pass filter (8) in the useful signal line (1) and a fourth all pass filter (91) provided to be used as a second input to the first branch (111) phase-shifted with respect to the second all pass filter (9) by 90 and a fifth all pass filter (101) provided to be used as a second input to the second branch (112) phase-shifted with respect to the third all pass filter (10) by 90 and

 - that in the useful signal line (1) downstream from the first and the second branch (111, 112) of the first network (11) delay pads are inserted.

2. Circuit for the reduction of intermodulation as per Claim 1 characterized by a parallel drive on the first and second branch (111, 112) of the nonlinear networks through a first and second line (13, 14) applied downstream from a common all pass filter pair (9, 91) for the partitioning and phase-shifting of the useful signal portion.

**Revendications**

1. Un circuit réduisant les produits d'intermodulation mélangés sur un signal de transmission sous utilisation de lasers à semi-conducteurs en télécommunication optique à l'aide d'un signal d'intermodulation artificiel en contre-phasé généré côté émetteur à partir d'un signal utile sur une ligne de signal utile (1) employant une étape d'attaque laser (2) ensuite ajouté au signal utile caractérisé du fait que

 - le circuit est muni d'un premier réseau (11) d'une caractéristique non-linéaire ainsi que d'un deuxième réseau cascadé (12) d'une caractéristique linéaire branchés sur la ligne de signal utile (1) en amont de l'étape d'attaque (2) à travers des coupleurs (3;21) pour la dérivation d'énergie de signal et d'un injecteur (6) pour l'injection de la partie traitée du signal;

 - le premier réseau (11) consiste à une première branche (111) pour la totalisation et une deuxième branche (112) pour la subtraction des produits d'intermodulation de deuxième ordre selon le principe du mélange à bande latérale unique avec suppression de la fréquence porteuse et une troisième branche (113) pour le traitement de l'intermodulation de troisième ordre;

 - le deuxième réseau (112) est construit de manière à être utilisé pour l'adaptation séparée des produits d'intermodulation générés dans les branches (111, 112 et 113) en phase et montant, c.-à-d.. pour les contre-phaser, à chaque caractéristique individuelle de laser;

 - des filtres passe-tout (8, 9, 10, 91, 101), en préférence de classe 2, c.-à-d. des passes-tout adaptables sont disponibles, un deuxième et un troisième passe tout (9; 10) étant pourvus en guise d'entrées premières aux lignes d'entrée des branches primaire et secondaire (111, 112) préférentiellement en phase avec le troisième passe-tout (8) dans la ligne de signal utile (1) et un quatrième passe-tout (91) pourvu à être utilisé comme entrée secondaire de la première branche (111) en quadrature avec le deuxième passe-tout (9) ainsi qu'un cinquième filtre passe-tout (101) pourvu à être utilisé comme deuxième entrée à la deuxième branche (112) en quadrature par rapport au troisième passe-tout (10)

- et que dans la ligne de signal utile (1) en descente des branches primaire et secondaire (111, 112) du premier réseau (11) il y a des bascules de retard.

2. Un circuit réduisant l'intermodulation d'après la la revendication 1 caractérisé par une attaque en parallèle sur les branches primaire et secondaire (111, 112) des réseaux non-linéaires à travers une première et une deuxième ligne de raccordement (13, 14) branchées en descente d'une paire de filtres passe-tout en commun (9, 91) pour la division et la quadrature de la portion du signal utile.

Figur 1

Figur 2

Figur 3

Figur 4